(19) Europäisches Patentamt
European Patent Office
Office européen des brevets

(11) **EP 3 720 001 B1**

(12) **EUROPEAN PATENT SPECIFICATION**

(45) Date of publication and mention
of the grant of the patent:
**10.11.2021 Bulletin 2021/45**

(51) Int Cl.:
**H03K 17/693** *(2006.01)*   **H03K 17/16** *(2006.01)*
**H04B 1/04** *(2006.01)*   **H04B 1/44** *(2006.01)*

(21) Application number: **20167503.0**

(22) Date of filing: **01.04.2020**

(54) **RADIO FREQUENCY SWITCH DEVICE WITH COMPENSATION AND COMPENSATION METHOD**

HOCHFREQUENZSCHALTVORRICHTUNG MIT KOMPENSATION UND KOMPENSATIONSVERFAHREN

DISPOSITIF DE COMMUTATION DE FRÉQUENCE RADIO AVEC COMPENSATION ET PROCÉDÉ DE COMPENSATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.04.2019 US 201916374139**

(43) Date of publication of application:
**07.10.2020 Bulletin 2020/41**

(73) Proprietor: **Infineon Technologies AG**
**85579 Neubiberg (DE)**

(72) Inventors:
• **SYROIEZHIN, Semen**
  **91504 Erlangen (DE)**
• **ARAUJO DO NASCIMENTO, Pablo**
  **81539 Munich (DE)**
• **BAKALSKI, Winfried**
  **85640 Putzbrunn (DE)**
• **CATTANEO, Andrea**
  **82024 Taufkirchen (DE)**
• **ESSEL, Jochen**
  **81679 Munich (DE)**
• **OEZDAMAR, Oguzhan**
  **85649 Brunnthal (DE)**
• **RIMMELSPACHER, Johannes Klaus**
  **80538 Munich (DE)**
• **SOLOMKO, Valentyn**
  **81479 München (DE)**
• **TAYARI, Danial**
  **82008 Unterhaching (DE)**
• **WICKMANN, Andreas**
  **90425 Nuernberg (DE)**

(74) Representative: **Sticht, Andreas**
**Kraus & Weisert**
**Patentanwälte PartGmbB**
**Thomas-Wimmer-Ring 15**
**80539 München (DE)**

(56) References cited:
**US-A1- 2015 035 582    US-A1- 2017 237 432**

**Description**

TECHNICAL FIELD

The present invention relates generally to a Radio Frequency switch having a compensation circuit and a corresponding compensation method.

BACKGROUND

High voltage radio frequency switches are known in the art for use in various applications such as the tuning of high voltage radio frequency antennas. Radio frequency switches typically comprise a plurality of transistors stacked in a series configuration between an radio frequency source and ground, and typically include an accompanying bias circuit for biasing nodes (also referred to as "terminals" herein) of the plurality of transistors. While the stacked configuration of the radio frequency switch is well suited for many applications, parasitic leakage currents can start to flow in and out of the plurality of transistors at extremely high peak radio frequency voltages (for example, in the case where the radio frequency switch is coupled between an radio frequency source and ground). The parasitic leakage currents can alter the designed bias voltage values of the bias circuit.

US 2017 / 237 432 A1 discloses a radio frequency device according to the preamble of claim 1 with two transistors coupled in series, where a bulk terminal of one of the transistors is coupled to a node between the transistors.

US 2015 / 035582 A1 discloses a network including a diode circuit.

SUMMARY

A radio frequency switch device as defined in claim 1 and a method as defined in claim 11 are provided. The dependent claims define further embodiments.

BRIEF DESCRIPTION OF THE DRAWINGS

For a more complete understanding of the present invention, and the advantages thereof, reference is now made to the following descriptions taken in conjunction with the accompanying drawings, in which:

Figure 1 illustrates a block diagram of an embodiment radio frequency system that includes a transceiver, an antenna tuner comprising a plurality of capacitors and radio frequency switches, an antenna, and a controller;

Figure 2A is a circuit diagram of an radio frequency switch arrangement including an exemplary bias network;

Figure 2B is a circuit diagram of the radio frequency switch arrangement of Figure 2A exposed to high radio frequency voltages, creating leakage currents and corresponding voltage shifts away from designed bias voltages;

Figure 3 is a circuit diagram of an embodiment radio frequency switch arrangement as in Figures 2A and 2B, but wherein the bias circuit is removed, and including a leakage current compensation circuit;

Figure 4 illustrates the typical I-V response of the leakage current compensation network shown in Figure 3, according to an embodiment;

Figure 5 is a circuit diagram illustrating the current distribution in a compensated radio frequency switch arrangement, including the biasing circuit, according to an embodiment;

Figure 6 illustrates examples of specific implementations of the compensation network, according to embodiments;

Figure 7 is a circuit diagram of another embodiment radio frequency switch arrangement, including a leakage current compensation circuit;

Figures 8A and 8B are circuit diagrams of another embodiment radio frequency switch arrangement, including leakage current compensation circuits;

Figures 9A and 9B are circuit diagrams of another embodiment radio frequency switch arrangement including a multiplicity of transistors, and including a multiplicity of leakage current compensation circuits;

Figures 10A, 10B, and 11 are circuit diagrams of another embodiment radio frequency switch arrangement including a multiplicity of transistors, including at least one leakage current compensation circuit;

Figure 12 is a circuit diagram of a PMOS-based radio frequency switch arrangement including a leakage current compensation circuit, according to an embodiment; and

Figure 13 is a circuit diagram of an radio frequency switch arrangement including an alternative biasing circuit.

Corresponding numerals and symbols in different figures generally refer to corresponding parts unless otherwise indicated. The figures are drawn to clearly illustrate the relevant aspects of the preferred embodiments and are not necessarily drawn to scale. To more clearly illustrate certain embodiments, a letter indicating variations of the same structure, material, or process step may follow a figure number.

## DETAILED DESCRIPTION OF ILLUSTRATIVE EMBODIMENTS

High voltage radio frequency switches described below may be used, for example, as antenna tuning switchable elements, and particularly in high voltage antenna tuning switches and tunable passive components like C-tuners (capacitor tuners), Z-tuners (impedance tuners) and the like. The high voltage radio frequency switches are typically used in cellular handheld devices to tune the impedance and radiation properties of compact antennas. They are typically attached between the feed or aperture points of an antenna and ground via external Surface Mount Device (SMD) capacitors or inductors.

In various embodiments illustrated and described below, one or more leakage current compensation circuits are used to mitigate the effect of leakage currents that flow from the drain and source to the body of a MOS transistor in an radio frequency switch arrangement. In various embodiments, these leakage compensation circuits may include non-linear elements, such as diodes or other rectifying elements. By compensating these leakage currents, leakage current induced shifts in the designed bias voltages of radio frequency switches can be mitigated and/or avoided.

The leakage currents referred to herein can include gate-induced drain and source leakage currents (GIDL and GISL) that flow from drain and source terminals into the bulk of the radio frequency switch transistors at high Vgs voltages. These GIDL/GISL leakage currents shift the operating point of the switch transistors in the radio frequency switch when flowing from and into the high-impedance biasing resistors. According to embodiments, the leakage compensation circuits described herein help to shift the operating point of the switch transistors in the radio frequency switch closer to the originally designed operating point despite the presence of significant leakage currents, when compared to an uncompensated radio frequency switch. The GIDL/GISL leakage currents are caused by quantum mechanical effects and changes in carrier transport within the switch transistor. The GIDL leakage current, for example, is caused at least in part by tunneling taking place in the narrow depletion region at the drain underneath the gate oxide.

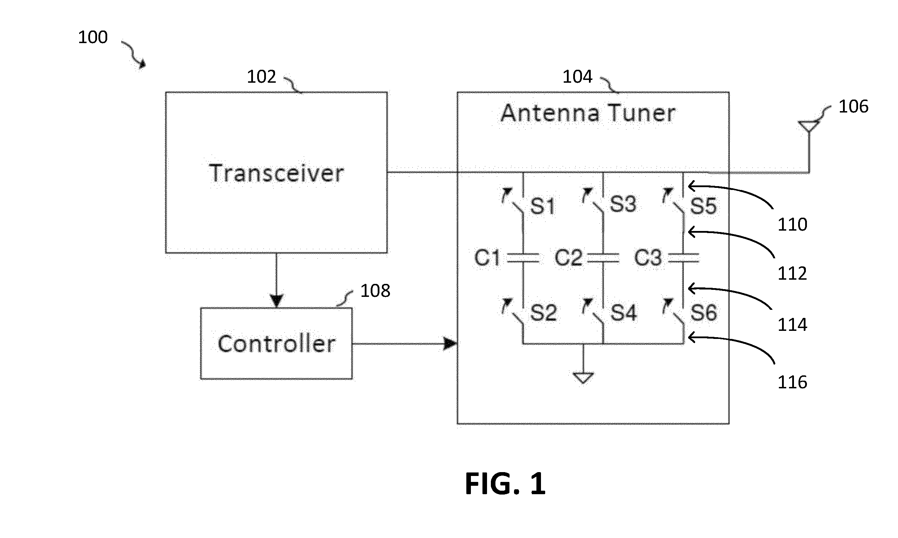

Figure 1 illustrates an radio frequency system 100 that may be configured to utilize embodiment radio frequency switching arrangements. As shown, radio frequency system 100 includes an radio frequency transceiver 102 coupled to an antenna 106 via antenna tuner 104. Antenna tuner includes shunt capacitors C1, C2 and C3 that can be selectively coupled to antenna 106 via switches S1, S2, S3, S4, S5 and S6. In various embodiments, switches S1, S2, S3, S4, S5 and S6 may be implemented using radio frequency switching arrangements described herein. During operation, controller 108 provides control signals that selectively turns-on and turns-off switch S1, S2, S3, S4, S5 and S6 according to an antenna setting provided by transceiver 102. The switch configuration of antenna tuner may be used to provide an radio frequency match between antenna 106 and transceiver 102 over a variety of frequencies. radio frequency system 100 may be used, for example, in multiband cellular communication applications. It should be understood that radio frequency system 100 is just one of many application examples that can utilize embodiment radio frequency switching arrangements. radio frequency switches can be used in applications requiring signal selection switches, for example, and in microwave test system applications for signal routing between instruments and devices under test.

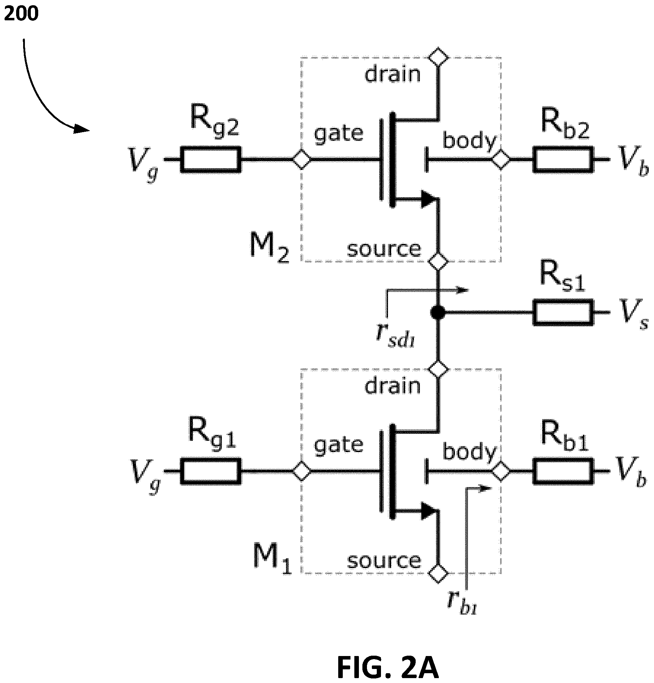

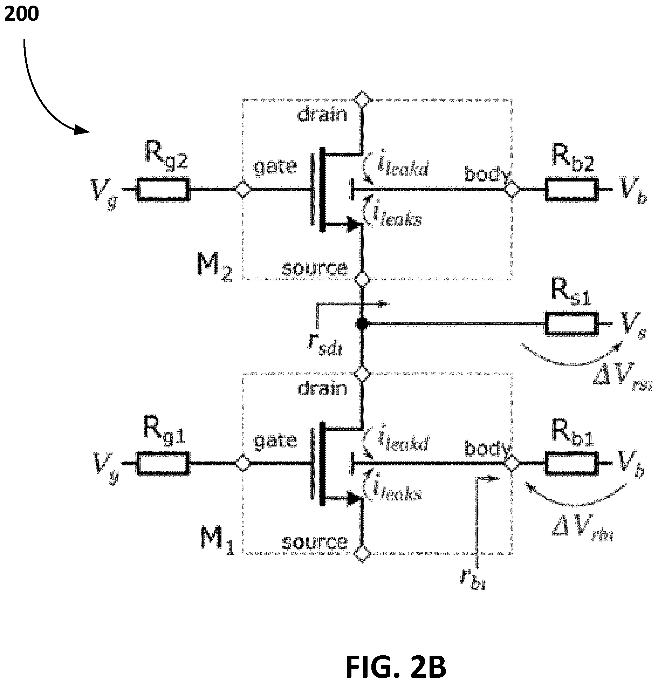

In Figure 1, representative radio frequency switch nodes 110, 112, 114, and 116 are also shown to further illustrate the applied radio frequency voltages across the switches. For example, a first switching node 110 of switch S5 is coupled to an radio frequency voltage source provided by antenna 106. A second switching node 112 is coupled to an intermediate radio frequency voltage source provided by a first node of capacitor C3. A first switching node 114 of switch S6 is coupled to another intermediate radio frequency voltage source provided by a second node of capacitor C3. A second switching node 116 of switch S6 is coupled directly to ground. Switches S5 and S6 are switched between the "on" state and the "off" state by application of a transistor gate voltage that is illustrated and described in further detail below with reference to Figures 2A and 2B. Thus, radio frequency switches can be placed between a first source of radio frequency voltage and a second source of radio frequency voltage, or between a source of radio frequency voltage and ground, in embodiments. Other radio frequency voltage sources can be used including radio frequency voltage sources for providing an alternating voltage signal, for example.

A typical challenge in antenna tuning switch design is to achieve high voltage handling at radio frequency frequencies, reaching values of 80 V peak or above, while sustaining the same or similar performance as at lower radio frequency voltages. The switches are implemented as stacked MOSFET devices on a silicon or other substrate.

In various embodiments, a MOS transistor used in radio frequency switch arrangements comprises a gate terminal, a source terminal, a drain terminal and a body terminal. The MOS transistor is biased to the desired operating point by the use of high-ohmic linear resistors. In some embodiments, a high-resistive DC path is provided for all terminals, including gate, source, drain and body terminals. After applying target DC voltages at each terminal via high-ohmic bias resistors the gate-source, gate-drain, drain-body and source-body voltages define the operating point of the MOS transistor in the switch arrangement.

Parasitic leakage currents may be generated at high operating voltages and can flow into the high-ohmic bias resistors generating significant voltage drops. Thus, the desired operating point of the high voltage radio frequency switch can be shifted from the desired operating point, causing a loss of performance, and in extreme cases, signal distortion.

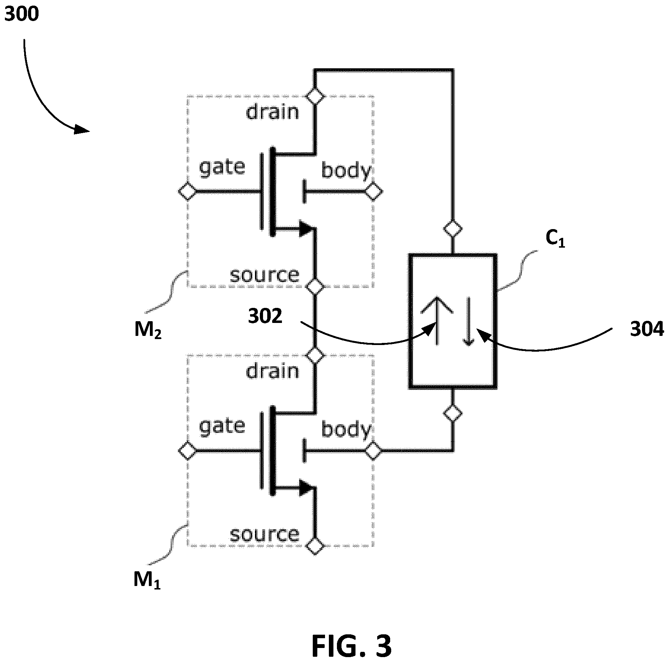

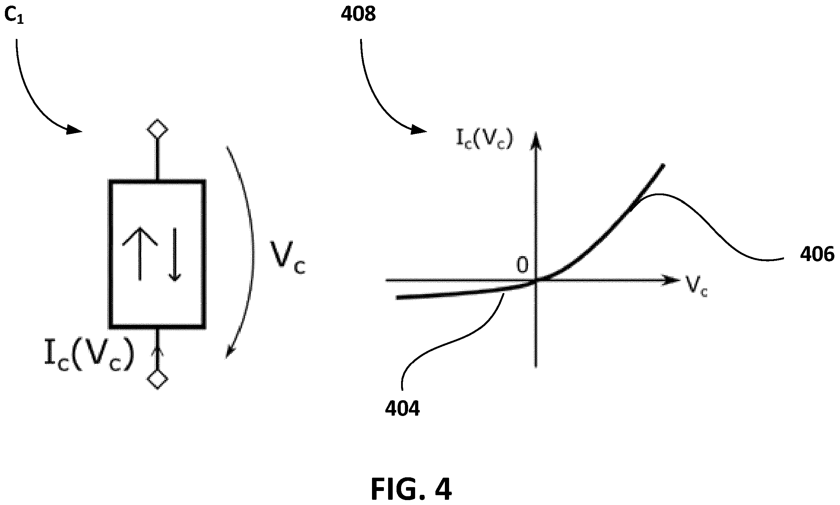

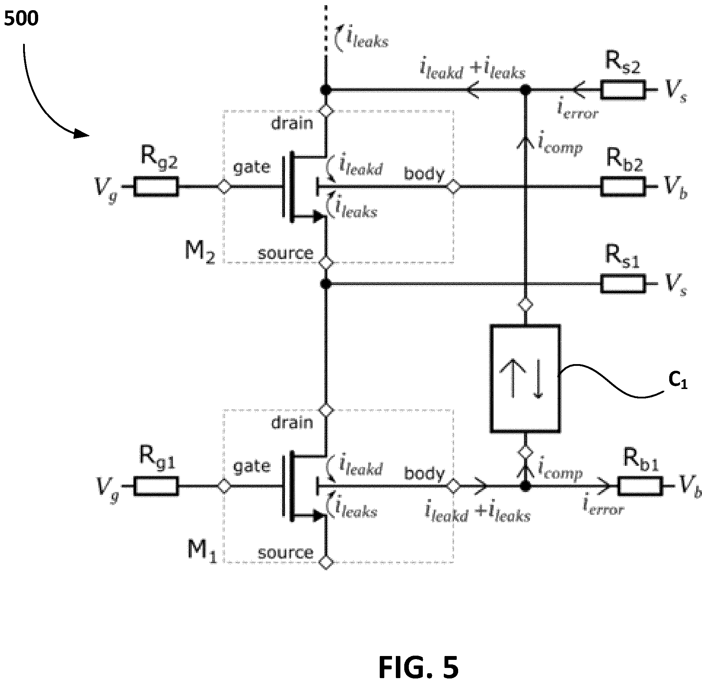

Figures 2A, 2B, 3, 4, and 5 show a sequence of circuit diagrams that are described below to further aid in understanding both the nature and effects of these leakage currents, and the solution provided by embodiment leakage compensation circuits. Figure 2A is a circuit diagram of a portion of an uncompensated radio frequency switch arrangement including a bias circuit which does not correspond to a claimed embodiment, but will be used for explanations. Figure 2B is the same circuit diagram as shown in Figure 2A which does not correspond to a claimed embodiment, but showing the gate induced drain and source leakage currents once the radio frequency switch arrangement is exposed to a high voltage radio frequency signal. Figure 3 is a circuit diagram of the same portion of the radio frequency switch arrangement, including the leakage current compensation circuit, but wherein the biasing circuitry is removed for ease of understanding the operation of the compensation circuit. Figure 4 illustrates the non-linear nature of the leakage compensation circuit, and Figure 5 shows the same portion of the radio frequency switch arrangement as previously illustrated, but including both the biasing circuitry and the leakage compensation circuit.

Figure 2A shows an exemplary circuit portion 200 of a high voltage radio frequency switch including a first NMOS transistor M1 in series connection with a second NMOS transistor M2. In the series connection, the source node of transistor M1 is coupled to the drain node of transistor M2. The drain node of transistor M2 is coupled directly to an radio frequency high voltage source, or indirectly through one or more transistors, also in series connection. The source node of transistor M1 is coupled directly to ground or to another radio frequency high voltage source, or indirectly through one or more transistors, also in series connection. The gate node of transistor M1 is coupled to gate bias voltage Vg through biasing resistor Rg1, and the gate node of transistor M2 is coupled to gate bias voltage Vg through biasing resistor Rg2. The body node of transistor M1 is coupled to body bias voltage Vb through biasing resistor Rb1, and the body node of transistor M2 is coupled to body bias voltage Vb through biasing resistor Rb2. The source-drain node between transistors M1 and M2 is coupled to the Vs bias voltage through resistor Rs1. The above-described biasing circuitry can be repeated and used for any additional series connected transistors not shown in Figure 2A. The gate nodes of the first and second transistors are switched to turn the transistors on and off. In an embodiment, the switchable current path though the switch is from the drain node to the source node of the second transistor M2 and from the drain node to the source node of the first transistor M1.

The radio frequency switch arrangement shown in Figure 2A provides a high impedance rsd1 at the source-drain nodes and rb1 at body nodes, with possibly different absolute values for rsd1 and rb1 for other radio frequency switch arrangements described below.

Figure 2B is a circuit diagram of the radio frequency switch arrangement 200 exposed to high radio frequency voltages. The circuit of Figure 2B is thus similar to the circuit shown in Figure 2A, except for the additional labeled leakage current and labeled shifted biasing voltages. The leakage currents generated from exposure to the applied high radio frequency voltages and their effect on the biasing circuitry is described in further detail below.

When the radio frequency switch 200 is exposed to high peak voltages at radio frequency frequencies (defined as the peak voltage at which the voltage drop across each individual transistor in the stack approaches maximum allowable level for a given MOS transistor type), parasitic leakage currents ileakd and ileaks start flowing from the drain and source terminals into the body terminals of the respective MOS transistor in the radio frequency switch arrangement. This current shifts the operating point of MOS transistors when flowing into respective high-ohmic bias resistors: the source voltage is shifted by the value of $\Delta V\_rs1=R\_s1$ (i_leakd+i_leaks ); and the body voltage is shifted by the value of $\Delta V\_rb1=R\_b1$ (i_leakd+i_leaks ). The bias-shifting effect of the parasitic leakage currents is illustrated in Figure 2.

Figures 2A and 2B are circuit diagrams of bias networks in radio frequency switch arrangements for radio frequency switch arrangements having two MOS transistors. While two transistors coupled in a series arrangement are shown in the circuits of Figures 2A and 2B, it will be appreciated by those skilled in the art that these circuits can be part of a larger high voltage radio frequency switch including a multiplicity of series-coupled transistors (for example, ten or twenty such transistors, in an embodiment). The total number of transistors used in the switch is determined by the breakdown voltage of each transistor in the switch, and the maximum applied peak radio frequency voltage that is switched.

Figure 3 is a circuit diagram 300 of an embodiment radio frequency switch arrangement (a switch arrangement is also referred to as an radio frequency switch device herein, and can refer to a compensated or uncompensated radio frequency switch comprising a plurality of radio frequency transistors in a series connected stacked configuration) including transistors M1 and M2, and a leakage current compensation circuit C1. In Figure 3, the biasing circuits previously shown in Figures 2A and 2B are not shown for ease in understanding the leakage current compensation circuit C1. Leakage current compensation circuit C1 can be used with the biasing circuits illustrated in Figures 2A or 2B, or other biasing circuits. Leakage current compensation circuit C1 can also be used with other biasing circuits. One or more leakage compensation circuits can be used in an radio frequency switch to direct leakage currents away from the biasing resistors and back into the radio frequency switch in such a manner that the desired biasing voltages are not shifted away from a designed nominal value. In embodiments, one or two compensation circuits are provided for each transistor in the radio frequency switch; however, a one-to-one correspondence between the compensation circuits and the transistors is not necessary. A plurality of compensation circuits less than a plurality of transistors in the radio frequency switch, or even one compensation circuit, will still have a positive effect on maintaining biasing voltages when compared to an uncompensated radio frequency switch.

According to an embodiment, a leakage current compensation circuit C1 comprising a non-linear compensation network is coupled between the body terminal of the first transistor M1 and the drain terminal of the second transistor M2 in the radio frequency switch arrangement 300 as shown in Figure 3. The nonlinear compensation network of leakage current compensation circuit C1 is configured to bypass a current in a first direction (large arrow designation 302) from the body terminal of the first transistor M1 towards the drain terminal of the second transistor M2 for a given voltage across the network and blocking a current in a second direction (small arrow designation 304) from the drain terminal of the second transistor M2 towards the body terminal of the first transistor M1 if the applied voltage is reversed. In this manner, the leakage currents are absorbed back into the radio frequency switch stack through the leakage compensation circuit and are not available to shift the desired biasing voltages as is described in further detail below, particularly with respect to the description of Figure 5.

In some embodiments, radio frequency switch arrangement 300, other radio frequency switch arrangements, as well as the individual switch transistors such as transistors M1 and M2 described herein are symmetrical so that the source and drain designations such as those shown in Figure 3 are interchangeable. In some embodiments, the individual switch transistors may be physically symmetrical, wherein the layout and configuration of the source and drain is substantially identical. Thus, the drain may be designated as a load terminal, and the source may also be designated as a load terminal. Thus, in Figure 3, radio frequency switch arrangement 300 comprises a first transistor M1 and a second transistor M2 coupled in series at a common node (source of transistor M2 and drain of transistor M1) to establish a switchable radio frequency path between a load terminal of transistor M2 (drain of transistor M2) and a load terminal of transistor M1 (source of transistor M1) and a compensation network coupled between a body terminal of transistor M1 and the load terminal of transistor M2, wherein the compensation network is configured to establish a path for current flowing between the body terminal of the first transistor and the load terminal of the second transistor in a first direction and to block current flowing therebetween in a second direction opposite to the first direction.

Figure 4 illustrates the typical I-V response 408 of the leakage current compensation network C1 according to an embodiment. In general terms, if the I-V characteristic 408 of the compensation network C1 is described by a function Ic(Vc), where Ic is a current flowing through the network 400 and Vc is a voltage applied over the network, as shown in

Figure 4, the following relation in equation [1] generally holds true:

$$Ic(Vc) > -Ic(-Vc). \qquad [1]$$

Equation [1] might not pertain under certain anomalous conditions, such as during breakdown conditions of the diodes or diode-connected transistors used in the compensation network.

Figure 5 is a circuit diagram illustrating the current distribution in a compensated radio frequency switch arrangement, according to an embodiment. Figure 5 shows the radio frequency switch circuit components and biasing components previously shown with respect to Figure 1A, and the leakage current labels shown in Figure 2, as well as the leakage current compensation circuit shown in Figure 3. In addition, Figure 5 includes an illustration of "error currents" flowing through the biasing resistors that are ideally minimized as is described in further detail below. The characteristic of the compensation network C1 is configured such that the average current flowing from the body terminal of the first transistor M1 into the drain terminal of the second transistor M2 is similar to (ileakd + ileaks) for a given radio frequency operating voltage, such that the leakage currents from the body terminal is forwarded mostly into the drain terminal of the second transistor and only a portion of the leakage current flows into the bias resistors, as shown in Figure 5.

The current in the compensated radio frequency switch arrangement are summed up as follows: Each MOS transistor in the radio frequency switch generates leakage current of (ileakd + ileaks); the compensation network bypasses the current of icomp between the body terminal of the first transistor M1 and the drain terminal of the second transistor M2; the error current of ierror, which is a difference between (ileakd + ileaks) and icomp flows into the bias resistors; and the leakage current compensation network C1 may be optimized to provide |ierror| < |ileakd + ileaks|, ideally |ierror| = 0. If the error current through bias resistors Rs2 and Rb1 is minimized or reduced, so is the corresponding voltage drop on these bias resistors, such that the shift of operating point at high power (high applied radio frequency voltage) is made smaller when compared to an uncompensated radio frequency switch arrangement. The current compensation network may be configured to provide a compensation current icomp exceeding the leakage current (ileakd + ileaks), such that ierror changes polarity and the radio frequency switch becomes overcompensated, meaning that the gate-source bias voltage of the radio frequency switch arrangement increases with the increase of applied radio frequency voltage.

Figure 5 thus demonstrates an example of a compensated radio frequency switch arrangement with a shunt body and drain/source bias network, according to the bias circuit shown in Figures 2A and 2B. Leakage current compensation circuit C1 can also be used with any other configuration of bias network if desired.

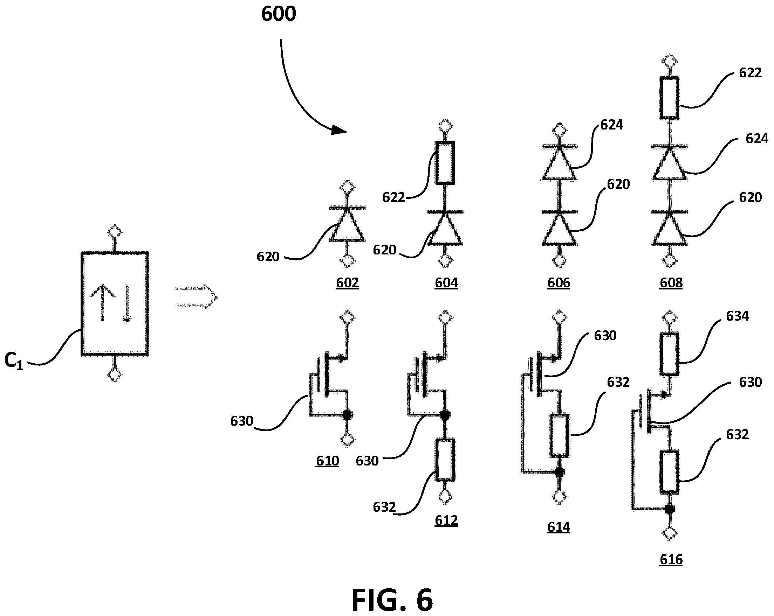

Figure 6 illustrates examples of specific implementations of the compensation network C1, according to embodiments.

Various implementations of the compensation network C1 providing the response that generally satisfies the relationship shown in Equation [1] (except for anomalous operating conditions, such as breakdown conditions) can be used. The network may be implemented using rectifying components such as passive components, including diodes, diodes and resistors, transistors in diode configurations, as well as combination of passive and active rectifying components, including amplifiers, operational amplifiers in feedback loops, and other similar circuits. The list of possible implementations for the compensation network C1 includes, but is not limited to:

A semiconductor diode circuit 602 comprising a single diode 620, also known as a p-n junction;

A semiconductor diode circuit 606 comprising plurality of semiconductor diodes 620 and 624 coupled in series;

A semiconductor diode circuit 604 comprising a semiconductor diode and a resistor 622;

A semiconductor diode circuit 608 comprising a plurality of semiconductor diodes 620 and 624 coupled in series with a resistor 622;

A transistor circuit 610 comprising a transistor 630 in a diode connection (diode-connected transistor);

A transistor circuit 612 comprising a transistor 630 in a diode connection coupled in series with a resistor 632; A transistor circuit 614 comprising a transistor 630 in a diode connection with a resistor 632 coupled in series with the channel; and

A circuit comprising a transistor 630 in a diode connection comprising multiple resistors 632 and 634 coupled in series.

Diodes in Figure 6 can be implemented by diffused regions in a silicon or other substrate, and can comprise a polysilicon diode, a Zener diode, a Schottky diode, or any other types of diodes. Diode-connected transistors can comprise diode-connected MOSFETS, diode-connected bipolar devices such as BJTs, junction field-effect transistors, as well as any other type of transistors. Resistors can comprise integrated circuit diffused or metal resistors and can be sized to match the peak leakage current, in an embodiment. For example, for leakage current circuit 604, the voltage across resistor 622 is determined by measuring the voltage across circuit 604 minus the voltage across diode 620. The remaining voltage across resistor 622 is divided by the peak leakage current desired to be compensated, to determine the value of resistor 622. Resistor 622 thus generates a matching current less than or equal to the peak leakage current. In the case of an overcompensated radio frequency switch, resistor 622 generates the matching current exceeding the peak leakage current.

There are also other implementations of the non-linear function previously described that can be used having rectifying properties, which allow bypassing a larger current in one direction than in the opposite direction. Many integrated and discrete components are available to implement the rectifying properties used in the leakage current compensation circuit described herein.

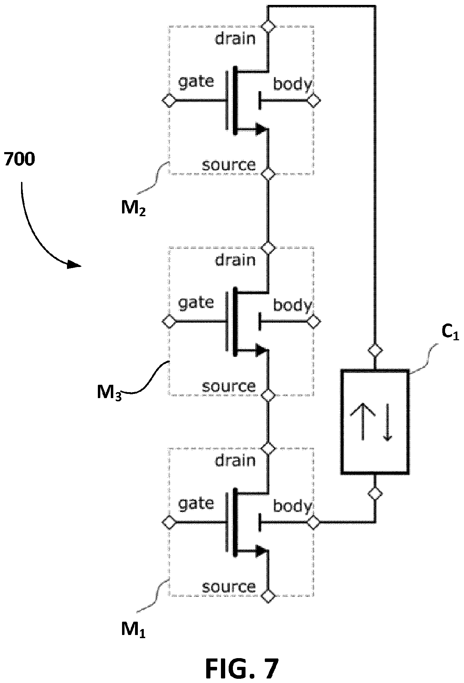

Figure 7 is a circuit diagram 700 of another embodiment radio frequency switch arrangement, including a leakage current compensation circuit C1 as previously described, with respect to, for example, Figure 3. While a biasing circuit is not shown in Figure 7 for ease of understanding circuit diagram 700, a biasing circuit would be implemented in a normal application. Transistors M1 and M2 and leakage current compensation circuit C1 shown in Figure 7 and their interconnections have been previously described. However, in Figure 7, note that an additional transistor M3 has been interposed in series connection between transistors M1 and M2. That is, the drain node of transistor M3 is coupled to the source node of transistor M2, and the source node of transistor M3 is coupled to the drain node of transistor M1. In the configuration shown in Figure 7, leakage currents flowing out of the body node of transistor M1 are bypassed through the action of leakage current compensation circuit C1 and flow into the drain of transistor M2. Additional transistors (one, two, or even more such transistors) in series connection such as transistor M3 can be interposed between transistors M1 and M2.

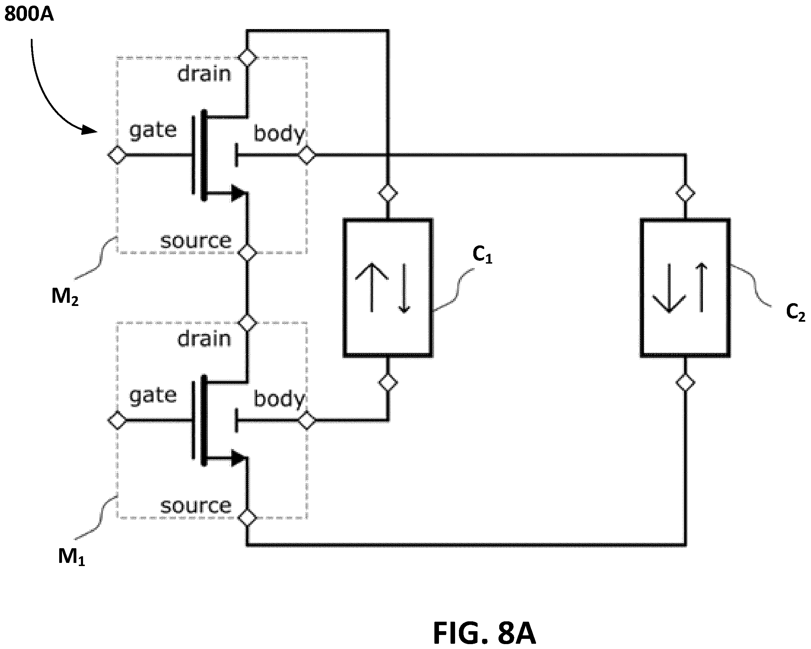

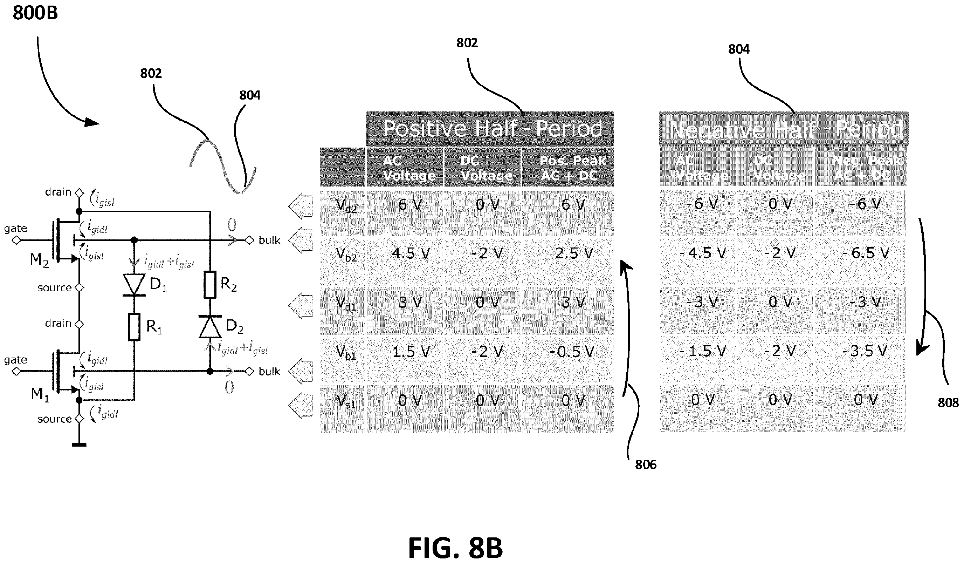

Figures 8A and 8B are circuit diagrams of another embodiment radio frequency switch arrangement, including leakage current compensation circuits for compensating leakage currents generated during both a positive half-period and a negative half-period of a sinusoidal or other periodic radio frequency signal waveform applied to the radio frequency switch arrangement. Again, the biasing circuit is omitted for clarity in Figures 8A and 8B, but would be included in a normal application.

Figure 8A illustrates a circuit 800A including transistors M1, M2, and leakage current compensation circuit C1, all previously described with respect to, for example, Figure 3. In addition, Figure 8A shows a second leakage current compensation circuit C2 coupled between the source node of transistor M1 and the body node of transistor M2. In the configuration shown in Figure 8A, leakage currents flowing out of the body node of transistor M1 are bypassed through the action of leakage current compensation circuit C1 and flow into the drain of transistor M2 in a first half-period of an applied radio frequency signal waveform. In the configuration shown in Figure 8A, leakage currents flowing out of the body node of transistor M2 are bypassed through the action of leakage current compensation circuit C2 and flow into the drain of transistor M1 in a second half-period of the applied radio frequency signal waveform. The action of compensation circuits C1 and C2 are explained in further detail below with reference to a specific example shown in Figure 8B.

Figure 8B illustrates a circuit 800B including transistors M1 and M2 as in Figure 8A. Leakage current compensation circuit C1 is shown in Figure 8B as a specific implementation including diode D1 and series connected resistor R1. Leakage current compensation circuit C2 is shown in Figure 8B as a specific implementation including diode D2 and series connected resistor R2. During a positive half-period 802 of an applied radio frequency voltage, the parasitic leakage currents igidl and igisl flow out of the bulk node of transistor M2 through diode D1 and resistor R1 and flow into the source node of transistor M1. If resistor R1 is sized correctly, the current flowing out of the bulk node of transistor M2 will be zero. During a negative half-period 804 of the applied radio frequency voltage, the parasitic leakage currents igidl and igisl flow out of the bulk node of transistor M1 through diode D2 and resistor R2 and flow into the drain node of transistor M2. If resistor R2 is sized correctly, the currently flowing out of the bulk of transistor M1 will be zero.

Exemplary DC biasing voltages and the peak AC applied radio frequency voltages during the positive half-period 802 and the negative half-period 804 are also illustrated in Figure 8B. The DC biasing voltages and the peak AC applied radio frequency voltages are only examples, and other voltages may be used in a different application. Different voltages will also appear if other transistors (not shown) different than transistors M1 and M2 in the radio frequency switch stack are analyzed.

During the positive half-period 802, the peak AC voltage at the drain node of transistor M2 (Vd2) is six volts, the peak AC voltage at the bulk node of transistor M2 (Vb2) is 4.5 volts, the peak AC voltage at the drain node of transistor M1 (Vd1) is three volts, and the peak AC voltage at the bulk node of transistor M1 (Vb1) is 1.5 volts. The source of transistor M1 is coupled to ground in Figure 8B. During the positive half-period 802, the DC biasing voltage at the drain node of transistor M2 (Vd2), the drain node of transistor M1 (Vd1), and the source node of transistor M1 (Vs1), are all set to zero volts. The DC biasing voltage at the bulk node of transistor M2 (Vb2) and the DC biasing voltage at the bulk node of transistor M1 (Vb1) are both set to negative two volts. The sum of the AC and DC voltages is thus six volts at the drain of transistor M2 (Vd2), 2.5 volts at the bulk node of transistor M2 (Vb2), three volts at the drain node of transistor M1 (Vd1), -0.5 volts at the bulk node of transistor M1 (Vb1), and zero volts at the source node of transistor M1. The voltage 806 across the first leakage compensation circuit comprising diode D1 and resistor R1 is thus 2.5 volts. Resistor R1 can therefore be appropriately sized to generate a corresponding compensation current less than or equal to the sum of parasitic leakage currents igidl and igisl so that only a small or no error current flows into or out of the bulk node of transistor M2.

During the negative half-period 804, the peak AC voltage at the drain node of transistor M2 (Vd2) is negative six volts, the peak AC voltage at the bulk node of transistor M2 (Vb2) is -4.5 volts, the peak AC voltage at the drain node of transistor M1 (Vd1) is negative three volts, and the peak AC voltage at the bulk node of transistor M1 (Vb1) is -1.5 volts. The source of transistor M1 is coupled to ground in Figure 8B. During the negative half-period 804, the DC biasing voltage at the drain node of transistor M2 (Vd2), the drain node of transistor M1 (Vd1), and the source node of transistor M1 (Vs1), are all set to zero volts. The DC biasing voltage at the bulk node of transistor M2 (Vb2) and the DC biasing voltage at the bulk node of transistor M1 (Vb1) are both set to negative two volts. The sum of the AC and DC voltages is thus negative six volts at the drain of transistor M2 (Vd2), -6.5 volts at the bulk node of transistor M2 (Vb2), negative three volts at the drain node of transistor M1 (Vd1), -3.5 volts at the bulk node of transistor M1 (Vb1), and zero volts at the source node of transistor M1. The voltage 808 across the second leakage compensation circuit comprising diode D2 and resistor R2 is thus -2.5 volts. Resistor R2 can therefore be appropriately sized to generate a corresponding compensation current less than or equal to the sum of parasitic leakage currents igidl and igisl so that only a small or no error current flows into or out of the bulk node of transistor M1.

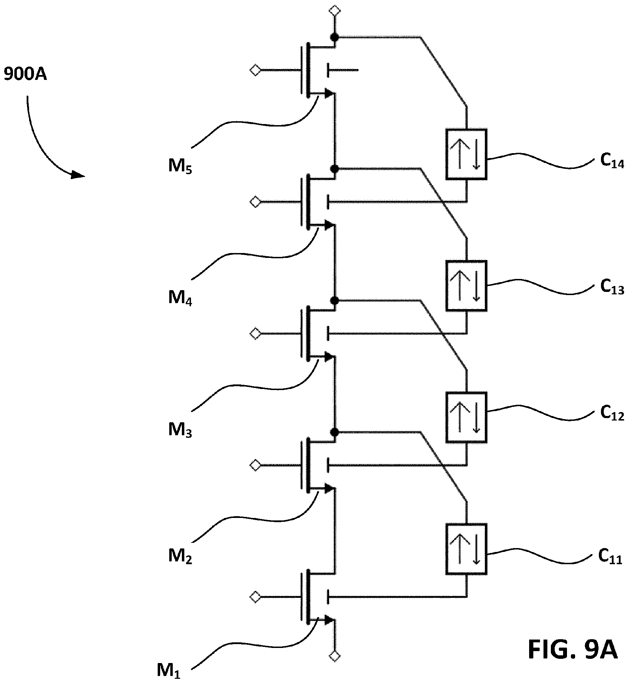

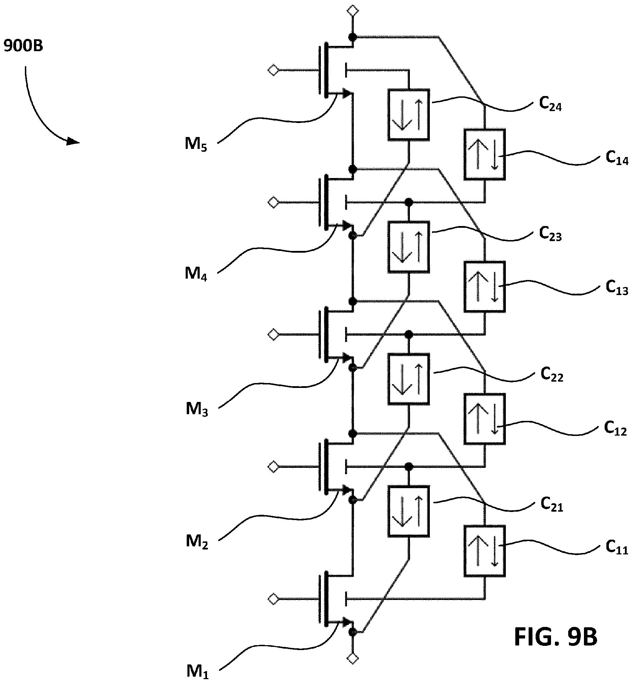

Figures 9A and 9B are circuit diagrams of another embodiment radio frequency switch arrangement including a multiplicity of transistors, and including a corresponding multiplicity of leakage current compensation circuits. In Figures 9A and 9B the biasing circuitry is not shown for clarity, but would typically be included in a normal operating configuration.

Figure 9A illustrates an radio frequency switch arrangement 900A comprising a plurality of transistors M1, M2, M3, M4, and M5 coupled in series between source and drain and a corresponding plurality of compensation networks C11, C12, C13, and C14 coupled between the body terminal of respective transistors in the radio frequency stack and the drain terminal of the adjacent transistors in radio frequency stack. In Figure 9A, any number of transistors can be used. The drain node of transistor M5 can be coupled to an radio frequency voltage source, or additional series connected transistors that are in turn coupled to an radio frequency voltage source. Likewise, the source node of transistors M1 can be coupled to another radio frequency voltage source or ground, or additional series connected transistors that are in turn coupled to another radio frequency voltage source or ground. In Figure 9A, the leakage currents flowing out of the body node of the transistors (in for example a negative half-period of the radio frequency voltage source) flow through the corresponding compensation networks and back into the radio frequency stack, so that the leakage currents cannot flow in the biasing circuitry (not shown in Figure 9A) as previously described.

Figure 9B illustrates an radio frequency switch arrangement 900B similar to that shown in Figure 9(a), but further comprising a plurality of anti-parallel compensation networks C21, C22, C23, and C24 coupled between the body node of respective transistors in the radio frequency stack and the drain node of the adjacent transistors in the radio frequency stack. In Figure 9B, the leakage currents flowing out of the body node of the transistors (in for example a positive half-period of the radio frequency voltage source) flow through the corresponding compensation networks and back into the radio frequency stack, so that the leakage currents cannot flow in the biasing circuitry (not shown in Figure 9B) as previously described. The radio frequency switch arrangement 900B shown in Figure 9B is thus configured for compensating leakage currents in both the half-periods of the sinusoidal or other periodic waveform of the applied radio frequency voltage. Also, in the radio frequency switch arrangement 900B of Figure 9B, there is a correspondence of two leakage current circuits (one for each half-period) to each of the transistors in the radio frequency stack. The configuration shown in Figure 9B provides the maximum compensation effect for the generated leakage currents.

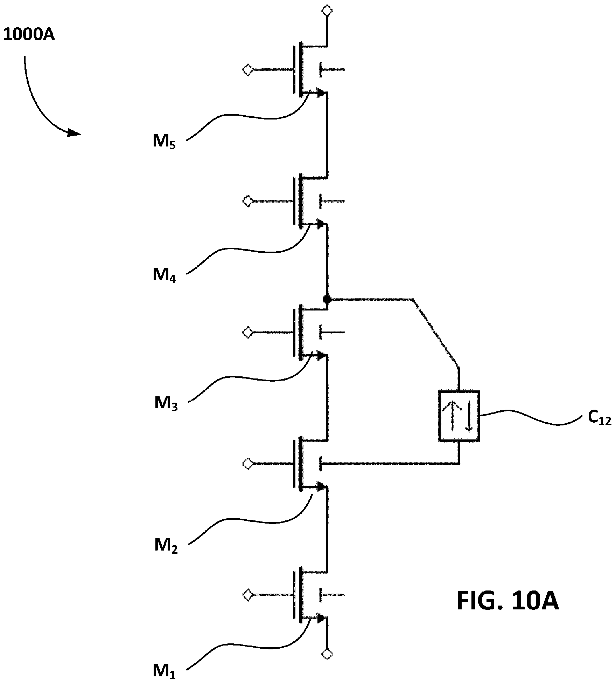

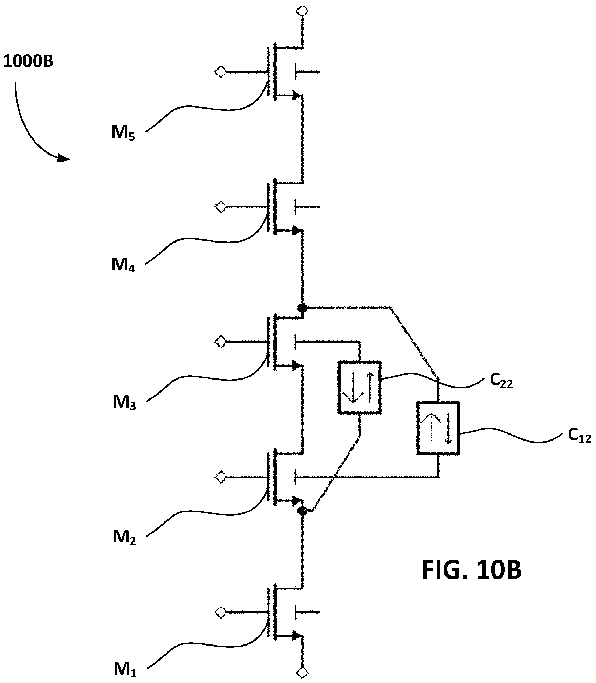

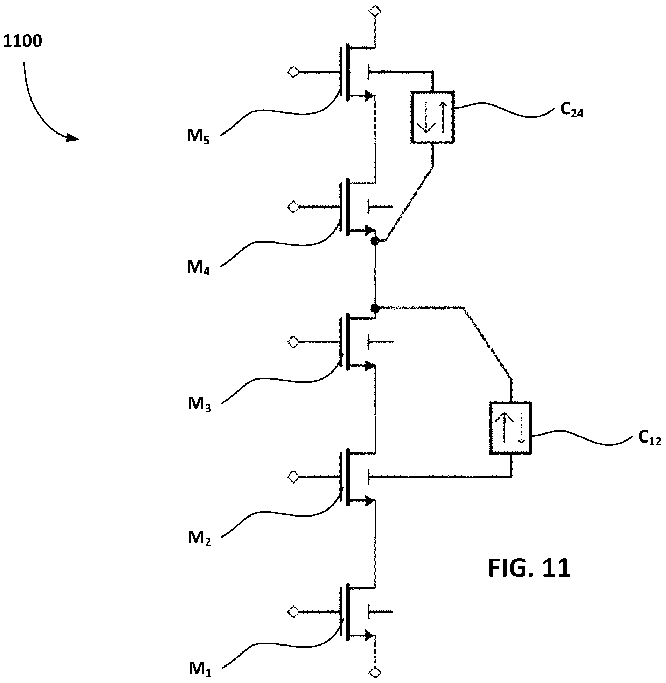

Figures 10A, 10B, and 11 are circuit diagrams of other embodiment radio frequency switch arrangements including a multiplicity of transistors, and including at least one leakage current compensation circuit. As previously described, while one or two leakage current compensation circuits per transistor may provide the maximum leakage current cancellation effect in embodiments, any number of leakage current compensation circuits less than one or two leakage current compensation circuits per transistor can be used. Even one leakage current compensation circuit per radio frequency switch will provide leakage current cancellation benefits, and corresponding improvement in maintaining bias voltages, when compared to an uncompensated radio frequency switch. Again, while Figures 10A, 10B, and 11 do not include biasing circuits for clarity, biasing circuits would typically be included in a normal application.

Figures 10A and Figure 10B show radio frequency switch arrangements similar to those shown in Figures 9A and 9B, but wherein fewer compensation networks are coupled with a subset of transistors from the same plurality of transistors in the radio frequency switch arrangement. For example, in Figure 10A, switch arrangement 1000A corresponds to switch arrangement 900A of Figure 9A, with the exception that only one compensation network C12 is used, which is coupled between the bulk node of transistor M2 and the drain node of transistor M3. In Figure 10B, switch arrangement 1000B corresponds to switch arrangement 900B of Figure 9B, with the exception that only two compensation networks C12 and C22 are used. Compensation network C12 is coupled between the bulk node of transistor M2 and the drain node of transistor M3, while compensation network C22 is coupled between the bulk node of transistor M3 and the source node of transistor M2. Other subsets of compensation networks can be used from the full set of compensation networks shown in Figures 9A and 9B. For example, while only compensation network C12 is depicted, only compensation network C11 or C13 could be used. Alternatively only compensation networks C11 and C14, or compensation networks C12 and C13, could be used. Regularly repeated patterns of compensation networks, or randomly interspersed compensation networks can be used to improve the leakage current characteristics of an radio frequency switch.

Another radio frequency switch arrangement 1100 is shown in Figure 11, wherein at least one first compensation network (C12) is coupled with a subset of transistors (transistors M2 and M3) from the plurality of transistors in radio frequency switch arrangement, and at least one second compensation network (C24) is coupled with another subset of transistors (transistors M4 and M5) from the plurality of transistors in radio frequency switch arrangement. Switch arrangement 1100 also generally corresponds to switch arrangement 900B of Figure 9B, with the exception that only compensation networks C12 and C24 are used. Other patterns of compensation networks and corresponding subsets of transistors can be used as desired. For example, certain patterns of compensation networks may be used to accommodate constraints placed on an integrated circuit layout. While compensation networks C12 and C24 are shown in Figure 11, other compensation networks can be used, for example, compensation networks C11 and C22, or compensation networks C13 and C22. Many other subsets of compensation networks can be used in Figure 11 that are selected from the maximum number of compensation networks shown in Figure 9B.

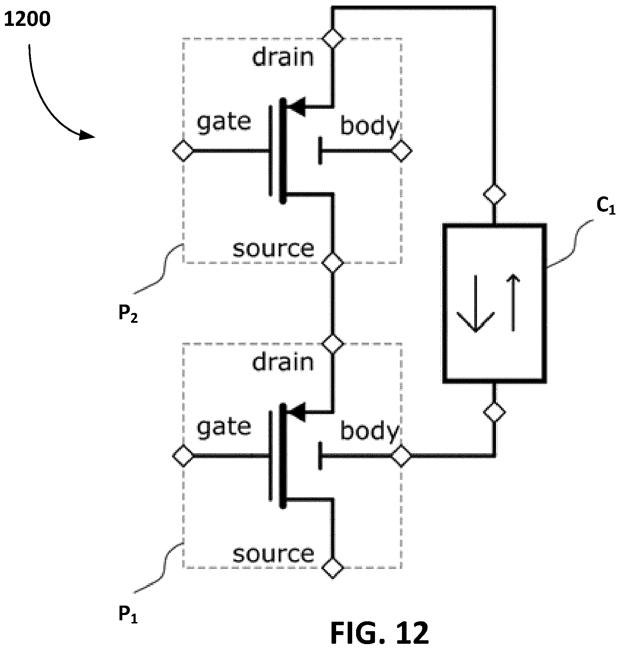

Figure 12 is a circuit diagram of a PMOS-based radio frequency switch arrangement 1200 including a leakage current compensation circuit C1, according to an embodiment. All embodiments described above are related to radio frequency switch arrangements implemented with NMOS switch transistors, which is a desirable way to implement radio frequency switches. However, if desired to accommodate a specific application, an radio frequency switch arrangement can also be implemented with PMOS transistors. Thus, switch arrangement 1200 includes a first PMOS transistor P1 and a second PMOS transistor P2. The drain node of transistor P1 is coupled to the source node of transistor P2. Compensation network C1 is coupled between the drain node of transistor P2 and the body node of transistor P1. The biasing network and the additional transistors, if any, in the switch arrangement 1200 are not shown in Figure 12. The previous description of the manner of operation of compensation network C1 also applies to the PMOS radio frequency switch embodiment shown in Figure 12, with the difference being that the compensation network polarity is reversed and the current direction is opposite. Figure 12 thus demonstrates the implementation of a compensated radio frequency switch using PMOS transistors.

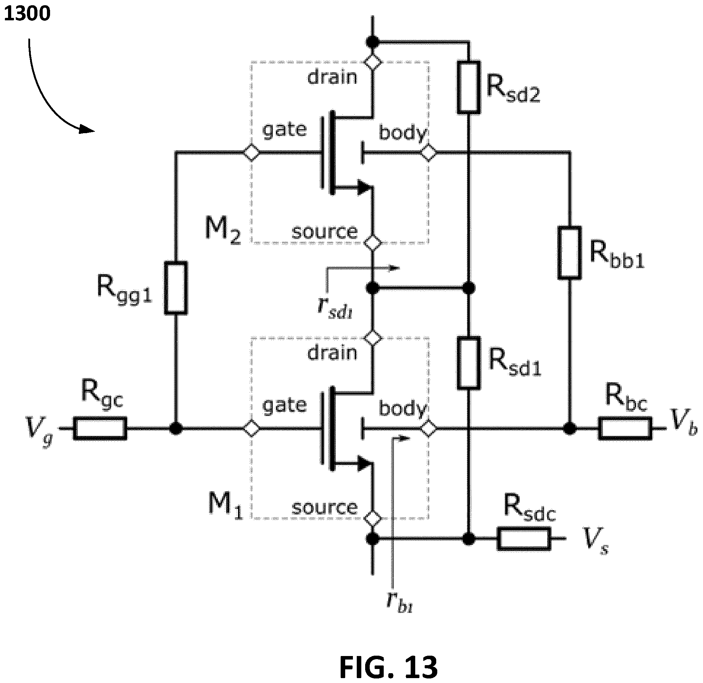

While a bias network for an radio frequency switch has been shown and described with respect to Figures 2A and 2B, various other possible arrangements of bias networks can be used, including but not limited to: High-ohmic resistors coupled between the gate, source-drain and body nodes of respective transistors in stack and the bias DC voltages Vg, Vb, Vs, as shown in Figures 2A and 2B; high-ohmic resistors coupled between the gate, source-drain and body nodes of respective transistors in stack, forming a series chain of bias resistors tapped to bias voltages at one or multiple points along the chain, as shown below in Figure 13; any combination of the biasing circuit arrangements shown in Figures 2A, 2B, and 13 used in a single high voltage radio frequency switch; or any combination of the biasing circuit arrangements shown in Figures 2A, 2B, and 13 used in the single high voltage radio frequency switch, where Vb and/or Vs are feedback-regulated bias voltages as described in US 2019 / 013 806 A1.

Figure 13 shows an exemplary circuit portion 1300 of a high voltage radio frequency switch including a first NMOS transistor M1 in series connection with a second NMOS transistor M2, and including an alternative biasing circuit. In the series connection, the source node of transistor M1 is coupled to the drain node of transistor M2. The drain node of transistor M2 is coupled directly to an radio frequency high voltage source, or indirectly through one or more transistors, also in series connection. The source node of transistor M1 is coupled directly to ground or to another radio frequency high voltage source, or indirectly through one or more transistors, also in series connection. The gate node of transistor M1 is coupled to gate bias voltage Vg through biasing resistor Rgc, and the gate node of transistor M2 is coupled to gate bias voltage Vg through biasing resistors Rgg1 and Rgc. The body node of transistor M1 is coupled to body bias voltage Vb through biasing resistor Rbc, and the body node of transistor M2 is coupled to body bias voltage Vb through biasing resistors and Rbb1 and Rbc. The source node of transistor M1 is coupled to the Vs bias voltage through resistor Rsdc. The source-drain node between transistors M1 and M2 is coupled to the Vs bias voltage through resistors Rsd1 and Rsdc. The drain node of transistor M2 is coupled to the Vs bias voltage through resistors Rsd2, Rsd1, and Rsdc. The above-described biasing circuitry can be repeated and used for any additional series connected transistors not shown in Figure 13. Any of the leakage current compensation circuits described herein can be used with the biasing circuit shown in Fig. 13.

Circuits using radio frequency switches with the leakage current compensation circuits described herein have advantages over circuits using uncompensated radio frequency switches, including but not limited to less introduced signal distortion, achieving good performance at higher operating voltages, as well as better reliability due to the avoidance of "hot spots" within the radio frequency switch due to excessive local voltages across individual switch transistors, and a better overall attainment of designed operating conditions despite the presence of leakage currents.

While matching leakage currents in radio frequency switch transistors with an equivalent compensation current generated by a leakage current compensation circuit is desirable as described herein, overcompensating or undercompensating those leakage currents with the leakage current compensation circuit will still provide benefits when compared to an uncompensated radio frequency switch.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein, wherein the scope of this invention is defined by the appended claims.

## Claims

1. A radio frequency switch device (300; 500; 700; 800A; 800B; 900A; 900B; 1000A; 1000B; 1100; 1200; 1300) comprising:

   a first transistor ($M_1$; $P_1$) and a second transistor ($M_2$; $P_2$), wherein one of a drain terminal or source terminal of the first transistor ($M_1$; $P_1$) is coupled to one of a source terminal or drain terminal, respectively, of the second transistor ($M_2$; $P_2$) such that the first and second transistors are coupled in series to establish a switchable radio frequency path; and **characterized by** a first compensation network ($C_1$; 602-616) coupled between a body terminal of the first transistor ($M_1$; $P_1$) and the other one of the drain terminal or source terminal of the second transistor ($M_2$; $P_2$),

   wherein the first compensation network ($C_1$; 602-616) is configured to establish a path for current flowing between the body terminal of the first transistor ($M_1$; $P_1$) and the other one of the drain terminal or source terminal of the second transistor ($M_2$; $P_2$) in a first direction (302) from the body terminal of the first transistor ($M_1$; $P_1$) to the other one of the drain terminal or source terminal of the second transistor ($M_2$; $P_2$) and to block current flowing in the first compensation network in a second direction (304) opposite to the first direction (302).

2. The radio frequency switch device (300; 500; 700; 800A; 800B; 900A; 900B; 1000A; 1000B; 1100; 1200; 1300) of claim 1, wherein the first compensation network ($C_1$; 602-616) is designed such that the current flowing in the first direction (302) is less than or equal to a leakage current associated with the body terminal of the first transistor ($M_1$; $P_1$).

3. The radio frequency switch device (300; 500; 700; 800A; 800B; 900A; 900B; 1000A; 1000B; 1100; 1200; 1300) of claim 2, wherein the leakage current associated with the body terminal of the first transistor ($M_1$; $P_1$) comprises a gate-induced source leakage current or a gate-induced drain leakage current.

4. The radio frequency switch device (300; 500; 700; 800A; 800B; 900A; 900B; 1000A; 1000B; 1100; 1200; 1300) of any one of claims 1 to 3, wherein the first compensation network ($C_1$; 602-616) comprises a diode circuit (602-608).

5. The radio frequency switch device (300; 500; 700; 800A; 800B; 900A; 900B; 1000A; 1000B; 1100; 1200; 1300) of claim 4, wherein the diode circuit comprises:
a first diode (620); a first diode (620) coupled in series with a resistor (622); a first diode (620) coupled in series with a second diode (624); or a first diode (620), a second diode (624), and a resistor (622) coupled in series.

6. The radio frequency switch device (300; 500; 700; 800A; 800B; 900A; 900B; 1000A; 1000B; 1100; 1200; 1300) of any one of claims 1 to 3, wherein the first compensation network ($C_1$; 602-616) comprises a diode-connected transistor circuit (610-616) .

7. The radio frequency switch device (300; 500; 700; 800A; 800B; 900A; 900B; 1000A; 1000B; 1100; 1200; 1300) of claim 6, wherein the diode-connected transistor circuit (610-616) comprises:
a diode-connected transistor (630); a diode-connected transistor coupled in series with a resistor (632); a diode-connected transistor (630) having a resistor (632) coupled between a drain terminal and a gate terminal of the diode-connected transistor; or a diode-connected transistor (630) having a first resistor (632) coupled between a drain terminal and a gate terminal of the diode-connected transistor, and a second resistor (634) coupled in series with a source terminal of the diode-connected transistor.

8. The radio frequency switch device (300; 500; 700; 800A; 800B; 900A; 900B; 1000A; 1000B; 1100; 1200; 1300) of any one of claims 1 to 7, further comprising a third transistor ($M_3$) having one of a drain terminal or source terminal coupled to the one of the source terminal or drain terminal, respectively, of the second transistor ($M_2$; $P_2$), and the other one of the drain terminal or source terminal coupled to the one of the drain terminal or source terminal of the first transistor ($M_1$; $P_1$).

9. The radio frequency switch device (300; 500; 700; 800A; 800B; 900A; 900B; 1000A; 1000B; 1100; 1200; 1300) of any one of claims 1 to 8, wherein the radio frequency switch device (300; 500; 700; 800A; 800B; 900A; 900B; 1000A; 1000B; 1100; 1200; 1300) further comprises a second compensation network ($C_2$) coupled between a body terminal of the second transistor ($M_2$; $P_2$) and the other one of the drain terminal or source terminal of the first transistor ($M_1$; $P_1$).

10. The radio frequency switch device (300; 500; 700; 800A; 800B; 900A; 900B; 1000A; 1000B; 1100; 1200; 1300) of claim 9, wherein the second compensation network ($C_2$) comprises a rectifying element, and/or
wherein the second compensation network ($C_2$) is designed such that the current flowing through the second compensation network ($C_2$) is less than or equal to a leakage current associated with the body terminal of the second transistor ($M_2$; $P_2$).

11. A method of compensating a radio frequency switch device (300; 500; 700; 800A; 800B; 900A; 900B; 1000A; 1000B; 1100; 1200; 1300) comprising a first transistor ($M_1$; $P_1$) and a second transistor ($M_2$; $P_2$) wherein one of a drain terminal or source terminal of the first transistor ($M_1$; $P_1$) is coupled to one of a source terminal or drain terminal, respectively, of the second transistor ($M_2$; $P_2$) such that the first and second transistors are coupled in series to establish a switchable current path, the method being **characterized by** generating , by a first compensation network ($C_1$; 602-616) coupled between body terminal of the first transistor ($M_1$; $P_1$) and the other one of the drain terminal or source terminal of the second transistor ($M_2$; $P_2$), a first compensation current flowing in the first compensation network in a first direction (302) from the body terminal of the first transistor ($M_1$; $P_1$) to the other one of the drain terminal or source terminal of the second transistor ($M_2$; $P_2$) and blocking by the first compensation network ($C_1$; 602-616), current flowing in the first compensation network in a second direction (304) opposite to the first direction (302).

12. The method of claim 11, further comprising generating , by a second compensation network ($C_2$) coupled between a body terminal of the second transistor ($M_2$; $P_2$) and the other one of the drain terminal or source terminal of the first transistor ($M_1$; $P_1$), a second compensation current flowing in the second compensation network in a third direction from the body terminal of the second transistor ($M_2$; $P_2$) to the other one of the drain terminal or source terminal of the first transistor ($M_1$; $P_1$) and blockinc , by the second compensation network ($C_2$), current flowing in the second compensation network in a fourth direction opposite to the third direction.

13. The method of claim 12, wherein the first compensation current is generated during a first half-period of an alternating voltage signal applied by a radio frequency voltage source, and the second compensation current is generated during a second half-period of the applied alternating voltage signal.

14. The method of claim 12 or 13, wherein the first compensation network ($C_1$; 602-616) is designed such that the first compensation current is less than or equal to a leakage current at the body terminal of the first transistor ($M_1$; $P_1$), and wherein the second compensation current is less than or equal to a leakage current at the body terminal of the second transistor ($M_2$; $P_2$).

15. The method of any one of claims 11 to 12, further comprising applying an alternating voltage signal to the radio frequency switch by a radio frequency voltage source.

**Patentansprüche**

1. Hochfrequenzschalter-Vorrichtung (300; 500; 700; 800A; 800B; 900A; 900B; 1000A; 1000B; 1100; 1200; 1300), die Folgendes umfasst:

   einen ersten Transistor ($M_1$; $P_1$) und einen zweiten Transistor ($M_2$; $P_2$), wobei der Drain-Anschluss oder der Source-Anschluss des ersten Transistors ($M_1$; $P_1$) jeweils mit einem Source-Anschluss oder einem Drain-Anschluss des zweiten Transistors ($M_2$; $P_2$) gekoppelt ist, so dass der erste und der zweite Transistor hintereinandergeschaltet sind, um einen schaltbaren Hochfrequenzpfad zu erstellen; und **gekennzeichnet durch** ein erstes Kompensationsnetzwerk ($C_1$; 602-616), das zwischen einen Body-Anschluss des ersten Transistors ($M_1$; $P_1$) und den anderen des Drain-Anschlusses oder des Source-Anschlusses des zweiten Transistors

($M_2$; $P_2$) geschaltet ist,
wobei das erste Kompensationsnetzwerk ($C_1$; 602-616) ausgelegt ist zum Erstellen eines Pfads für Strom, der zwischen dem Body-Anschluss des ersten Transistors ($M_1$; $P_1$) und dem anderen des Drain-Anschlusses oder des Source-Anschlusses des zweiten Transistors ($M_2$; $P_2$) in einer ersten Richtung (302) von dem Body-Anschluss des ersten Transistors ($M_1$; $P_1$) zu dem anderen des Drain-Anschlusses oder des Source-Anschlusses des zweiten Transistors ($M_2$; $P_2$) fließt, und zum Blockieren von Strom, der in dem ersten Kompensationsnetzwerk in einer zweiten Richtung (304), die der ersten Richtung (302) entgegengesetzt ist, fließt.

2. Hochfrequenzschalter-Vorrichtung (300; 500; 700; 800A; 800B; 900A; 900B; 1000A; 1000B; 1100; 1200; 1300) nach Anspruch 1, wobei das erste Kompensationsnetzwerk ($C_1$; 602-616) derart designt ist, dass der in der ersten Richtung (302) fließende Strom kleiner oder gleich einem Leckstrom ist, der mit dem Body-Anschluss des ersten Transistors ($M_1$; $P_1$) assoziiert ist.

3. Hochfrequenzschalter-Vorrichtung (300; 500; 700; 800A; 800B; 900A; 900B; 1000A; 1000B; 1100; 1200; 1300) nach Anspruch 2, wobei der mit dem Body-Anschluss des ersten Transistors ($M_1$; $P_1$) assoziierte Leckstrom einen Gate-induzierten Source-Leckstrom oder einen Gate-induzierten Drain-Leckstrom umfasst.

4. Hochfrequenzschalter-Vorrichtung (300; 500; 700; 800A; 800B; 900A; 900B; 1000A; 1000B; 1100; 1200; 1300) nach einem der Ansprüche 1 bis 3, wobei das erste Kompensationsnetzwerk ($C_1$; 602-616) eine Diodenschaltung (602-608) umfasst.

5. Hochfrequenzschalter-Vorrichtung (300; 500; 700; 800A; 800B; 900A; 900B; 1000A; 1000B; 1100; 1200; 1300) nach Anspruch 4, wobei die Diodenschaltung Folgendes umfasst:
   eine erste Diode (620); eine erste Diode (620), mit einem Widerstand (622) in Reihe geschaltet; eine erste Diode (620), mit einer zweiten Diode (624) in Reihe geschaltet; oder eine erste Diode (620), eine zweite Diode (624) und einen Widerstand (622), in Reihe geschaltet.

6. Hochfrequenzschalter-Vorrichtung (300; 500; 700; 800A; 800B; 900A; 900B; 1000A; 1000B; 1100; 1200; 1300) nach einem der Ansprüche 1 bis 3, wobei das erste Kompensationsnetzwerk ($C_1$; 602-616) eine Als-Diode-Verbundener-Transistor-Schaltung (610-616) umfasst.

7. Hochfrequenzschalter-Vorrichtung (300; 500; 700;

800A; 800B; 900A; 900B; 1000A; 1000B; 1100; 1200; 1300) nach Anspruch 6, wobei die Als-Diode-Verbundener-Transistor-Schaltung (610-616) Folgendes umfasst:

einen Als-Diode-Verbundener-Transistor (630); einen Als-Diode-Verbundener-Transistor, mit einem Widerstand (632) in Reihe geschaltet; einen Als-Diode-Verbundener-Transistor (630), der einen Widerstand (632) aufweist, der zwischen einen Drain-Anschluss und einen Gate-Anschluss des Als-Diode-Verbundener-Transistors geschaltet ist; oder einen Als-Diode-Verbundener-Transistor (630), der einen ersten Widerstand (632), der zwischen einen Drain-Anschluss und einen Gate-Anschluss des Als-Diode-Verbundener-Transistors geschaltet ist, und einen zweiten Widerstand (634), der mit einem Source-Anschluss des Als-Diode-Verbundener-Transistors in Reihe geschaltet ist, aufweist.

8. Hochfrequenzschalter-Vorrichtung (300; 500; 700; 800A; 800B; 900A; 900B; 1000A; 1000B; 1100; 1200; 1300) nach einem der Ansprüche 1 bis 7, ferner umfassend einen dritten Transistor ($M_3$), dessen Drain-Anschluss oder Source-Anschluss jeweils mit dem Source-Anschluss oder dem Drain-Anschluss des zweiten Transistors ($M_2$; $P_2$) gekoppelt ist, und der andere des Drain-Anschlusses oder des Source-Anschlusses mit dem Drain-Anschluss oder dem Source-Anschluss des ersten Transistors ($M_1$; $P_1$) gekoppelt ist.

9. Hochfrequenzschalter-Vorrichtung (300; 500; 700; 800A; 800B; 900A; 900B; 1000A; 1000B; 1100; 1200; 1300) nach einem der Ansprüche 1 bis 8, wobei die Hochfrequenzschalter-Vorrichtung (300; 500; 700; 800A; 800B; 900A; 900B; 1000A; 1000B; 1100; 1200; 1300) ferner ein zweites Kompensationsnetzwerk ($C_2$) umfasst, das zwischen einen Body-Anschluss des zweiten Transistors ($M_2$; $P_2$) und den anderen des Drain-Anschlusses oder des Source-Anschlusses des ersten Transistors ($M_1$; $P_1$) geschaltet ist.

10. Hochfrequenzschalter-Vorrichtung (300; 500; 700; 800A; 800B; 900A; 900B; 1000A; 1000B; 1100; 1200; 1300) nach Anspruch 9, wobei das zweite Kompensationsnetzwerk ($C_2$) ein gleichrichtendes Element umfasst, und/oder wobei das zweite Kompensationsnetzwerk ($C_2$) derart designt ist, dass der durch das zweite Kompensationsnetzwerk ($C_2$) fließende Strom kleiner oder gleich einem Leckstrom ist, der mit dem Body-Anschluss des zweiten Transistors ($M_2$; $P_2$) assoziiert ist.

11. Verfahren zum Kompensieren einer Hochfrequenzschalter-Vorrichtung (300; 500; 700; 800A; 800B; 900A; 900B; 1000A; 1000B; 1100; 1200; 1300) umfassend einen ersten Transistor ($M_1$; $P_1$) und einen zweiten Transistor ($M_2$; $P_2$), wobei ein Drain-Anschluss oder ein Source-Anschluss des ersten Transistors ($M_1$; $P_1$) jeweils mit einem Source-Anschluss oder einem Drain-Anschluss des zweiten Transistors ($M_2$; $P_2$) gekoppelt ist, so dass der erste und der zweite Transistor hintereinandergeschaltet sind, um einen schaltbaren Strompfad zu erstellen, wobei das Verfahren **gekennzeichnet ist durch** Erzeugen, durch ein erstes Kompensationsnetzwerk ($C_1$; 602-616), das zwischen einen Body-Anschluss des ersten Transistors ($M_1$; $P_1$) und den anderen des Drain-Anschlusses oder des Source-Anschlusses des zweiten Transistors ($M_2$; $P_2$) geschaltet ist, eines ersten Kompensationsstroms, der in dem ersten Kompensationsnetzwerk in einer ersten Richtung (302) von dem Body-Anschluss des ersten Transistors ($M_1$; $P_1$) zu dem anderen des Drain-Anschlusses oder des Source-Anschlusses des zweiten Transistors ($M_2$; $P_2$) fließt, und Blockieren, durch das erste Kompensationsnetzwerk ($C_1$; 602-616), von Strom, der in dem ersten Kompensationsnetzwerk in einer zweiten Richtung (304), die der ersten Richtung (302) entgegengesetzt ist, fließt.

12. Verfahren nach Anspruch 11, ferner umfassend Erzeugen, durch ein zweites Kompensationsnetzwerk ($C_2$), das zwischen einen Body-Anschluss des zweiten Transistors ($M_2$; $P_2$) und den anderen des Drain-Anschlusses oder des Source-Anschlusses des ersten Transistors ($M_1$; $P_1$) geschaltet ist, eines zweiten Kompensationsstroms, der in dem zweiten Kompensationsnetzwerk in einer dritten Richtung von dem Body-Anschluss des zweiten Transistors ($M_2$; $P_2$) zu dem anderen des Drain-Anschlusses oder des Source-Anschlusses des ersten Transistors ($M_1$; $P_1$) fließt, und Blockieren, durch das zweite Kompensationsnetzwerk ($C_2$), eines Stroms, der in dem zweiten Kompensationsnetzwerk in einer vierten Richtung, die der dritten Richtung entgegengesetzt ist, fließt.

13. Verfahren nach Anspruch 12, wobei der erste Kompensationsstrom während einer ersten Halbperiode eines Wechselspannungssignals, das durch eine Hochfrequenz-Spannungsquelle angelegt wird, erzeugt wird und der zweite Kompensationsstrom während einer zweiten Halbperiode des angelegten Wechselspannungssignals erzeugt wird.

14. Verfahren nach Anspruch 12 oder 13, wobei das erste Kompensationsnetzwerk ($C_1$; 602-616) derart designt ist, dass der erste Kompensationsstrom kleiner oder gleich einem Leckstrom an dem Body-Anschluss des ersten Transistors ($M_1$; $P_1$) ist, und wobei der zweite Kompensationsstrom kleiner oder gleich einem Leckstrom an dem Body-Anschluss des zweiten Transistors (M$_2$; P$_2$) ist.

15. Verfahren nach einem der Ansprüche 11 bis 12, ferner umfassend Anlegen eines Wechselspannungssignals an den Hochfrequenzschalter durch eine Hochfrequenz-Spannungsquelle.

**Revendications**

1. Dispositif (300 ; 500 ; 700 ; 800A ; 800B ; 900A ; 1000A ; 1000B ; 1100 ; 1200 ; 1300) de coupure de fréquence radio comprenant :

    un premier transistor (M$_1$ ; P$_1$) et un deuxième transistor (M$_2$ ; P$_2$), dans lequel l'une d'une borne de drain ou d'une borne de source du premier transistor (M$_1$ ; P$_1$) est connectée à l'une d'une borne de source ou d'une borne de drain, respectivement, du deuxième transistor (M$_2$ ; P$_2$) de manière à ce que le premier et le deuxième transistors soient montés en série pour établir un trajet de fréquence radio pouvant être interrompu ; et **caractérisé par**
    un premier réseau (C$_1$ ; 602 à 616) de compensation monté entre une borne de substrat du premier transistor (M1 ; P1) et l'autre de la borne de drain ou de la borne de source du deuxième transistor (M2 ; P2),
    dans lequel le premier réseau (C$_1$ ; 602 à 616) de compensation est configuré pour établir un trajet de passage du courant entre la borne de substrat du premier transistor (M1 ; P1) et l'autre de la borne de drain ou de la borne de source du deuxième transistor (M2 ; P2) dans un premier sens (302) de la borne de substrat du premier transistor (M1 ; P1) à l'autre de la borne de drain ou de la borne de source du deuxième transistor (M2 ; P2) et pour bloquer le passage de courant dans le premier réseau de compensation dans un deuxième sens (304) contraire au premier sens (302).

2. Dispositif (300 ; 500 ; 700 ; 800A ; 800B ; 900A ; 1000A ; 1000B ; 1100 ; 1200 ; 1300) de coupure de fréquence radio suivant la revendication 1, dans lequel le premier réseau (C$_1$ ; 602 à 616) de compensation est conçu de manière à ce que le courant passant dans le premier sens (302) soit inférieur ou égal à un courant de fuite associé à la borne de substrat du premier transistor (M1 ; P1).

3. Dispositif (300 ; 500 ; 700 ; 800A ; 800B ; 900A ; 1000A ; 1000B ; 1100 ; 1200 ; 1300) de coupure de fréquence radio suivant la revendication 2, dans lequel le courant de fuite associé à la borne de substrat du premier transistor (M1 ; P1) comprend un courant de fuite de source induit par la grille ou un courant de fuite de drain induit par la grille.

4. Dispositif (300 ; 500 ; 700 ; 800A ; 800B ; 900A ; 1000A ; 1000B ; 1100 ; 1200 ; 1300) de coupure de fréquence radio suivant l'une quelconque des revendications 1 à 3, dans lequel le premier réseau (C$_1$ ; 602 à 616) de compensation comprend un circuit (602 à 608) de diodes.

5. Dispositif (300 ; 500 ; 700 ; 800A ; 800B ; 900A ; 1000A ; 1000B ; 1100 ; 1200 ; 1300) de coupure de fréquence radio suivant la revendication 4, dans lequel le circuit de diodes comprend :
    une première diode (620) ; une première diode (620) montée en série avec une résistance (622) ; une première diode (620) montée en série avec une deuxième diode (624) ou une première diode (620), une deuxième diode (624) et une résistance (622) montées en série.

6. Dispositif (300 ; 500 ; 700 ; 800A ; 800B ; 900A ; 1000A ; 1000B ; 1100 ; 1200 ; 1300) de coupure de fréquence radio suivant l'une quelconque des revendications 1 à 3, dans lequel le premier réseau (C$_1$ ; 602 à 616) de compensation comprend un circuit (610 à 616) de transistors connecté par diode.

7. Dispositif (300 ; 500 ; 700 ; 800A ; 800B ; 900A ; 1000A ; 1000B ; 1100 ; 1200 ; 1300) de coupure de fréquence radio suivant la revendication 6, dans lequel le circuit (610 à 616) transistors connecté par diode comprend :
    un transistor (630) connecté par diode; un transistor connecté par diode monté en série avec une résistance (632) ; un transistor (630) connecté par diode ayant une résistance (632) montée entre une borne de drain et une borne de grille du transistor connecté par diode ; ou un transistor (630) connecté par diode et une première résistance (632) montée entre une borne de drain et une borne de grille du transistor connecté par diode et une deuxième résistance (634) montée en série avec une borne de source du transistor connecté par diode.

8. Dispositif (300 ; 500 ; 700 ; 800A ; 800B ; 900A ; 1000A ; 1000B ; 1100 ; 1200 ; 1300) de coupure de fréquence radio suivant l'une quelconque des revendications 1 à 7, comprenant en outre un troisième transistor (M3) ayant l'une d'une borne de drain ou d'une borne de source connectée à l'une d'une borne de source ou d'une borne de drain, respectivement, du deuxième transistor (M2 ; P2) et l'autre de la borne de drain ou de la borne de source connectée à l'une de la borne de drain ou de la borne de source du premier transistor (M1 ; P1).

9. Dispositif (300 ; 500 ; 700 ; 800A ; 800B ; 900A ;

1000A ; 1000B ; 1100 ; 1200 ; 1300) de coupure de fréquence radio suivant l'une quelconque des revendications 1 à 8, le dispositif (300 ; 500 ; 700 ; 800A ; 800B ; 900A ; 1000A ; 1000B ; 1100 ; 1200 ; 1300) de coupure à fréquence radio comprend en outre un deuxième réseau (C2) de compensation monté entre une borne de substrat du deuxième transistor (M2 ; P2) et l'autre de la borne de drain ou de la borne de source du premier transistor (M1 ; P1) .

10. Dispositif (300 ; 500 ; 700 ; 800A ; 800B ; 900A ; 1000A ; 1000B ; 1100 ; 1200 ; 1300) de coupure de fréquence radio suivant la revendication 9, dans lequel le deuxième réseau (C2) de compensation comprend un élément redresseur et/ou
dans lequel le deuxième réseau (C2) de compensation est conçu de manière à ce que le courant passant dans le deuxième réseau (C2) de compensation soit inférieur ou égal à un courant de fuite associé à la borne de substrat du deuxième transistor (M2 ; P2).

11. Procédé de compensation d'un dispositif (300 ; 500 ; 700 ; 800A ; 800B ; 900A ; 1000A ; 1000B ; 1100 ; 1200 ; 1300) de coupure à fréquence radio comprenant :
un premier transistor ($M_1$ ; $P_1$) et un deuxième transistor ($M_2$ ; $P_2$), dans lequel l'une d'une borne de drain ou d'une borne de source du premier transistor ($M_1$ ; $P_1$) est connectée à l'une d'une borne de source ou d'une borne de drain, respectivement du deuxième transistor ($M_2$ ; $P_2$) de manière à ce que le premier et le deuxième transistors soient montés en série pour établir un trajet de fréquence radio pouvant être interrompu, le procédé étant **caractérisé en ce que** l'on produit par le premier réseau (C1 ; 602 à 616) de compensation monté entre une borne de substrat du premier transistor ($M_1$ ; $P_1$) et l'autre de la borne de drain ou la borne de source du deuxième transistor ($M_2$ ; $P_2$) un premier courant de compensation passant dans le premier réseau de compensation dans un premier sens (302) de la borne de substrat du premier transistor (M1 ; P1) à l'autre de la borne de drain ou la borne de source du deuxième transistor ($M_2$ ; $P_2$) et on bloque par le premier réseau (C1 ; 602 à 616) de compensation du courant passant dans le premier réseau de compensation dans un deuxième sens (304) contraire au premier sens (302).

12. Procédé suivant la revendication 11, dans lequel en outre on produit par le deuxième réseau (C2) de compensation monté entre une borne de substrat du deuxième transistor (M2 ; P2) et l'autre de la borne de drain ou de la borne de source du premier transistor (M1 ; P1) un deuxième courant de compensation passant dans le deuxième réseau de compensation dans un troisième sens de la borne de substrat du deuxième transistor (M2 ; P2) à l'autre de la borne de drain ou de la borne de source du premier transistor (M1 ; P1) et on bloque par le deuxième réseau (C2) de compensation du courant passant dans le deuxième réseau de compensation dans une quatrième direction contraire à la troisième direction.

13. Procédé suivant la revendication 12, dans lequel on produit le premier courant de compensation pendant une première demi-période d'un signal de tension alternative appliqué par une source de tension de fréquence radio et on produit le deuxième courant de compensation pendant une deuxième demi-période du signal de tension alternative appliqué.

14. Procédé suivant la revendication 12 ou 13, dans lequel on conçoit le premier réseau (C1 ; 602 à 616) de compensation de manière à ce que le premier courant de compensation soit inférieur ou égal à une courant de fuite à la borne de substrat du premier transistor (M1 ; P1) et dans lequel le deuxième courant de compensation est inférieur ou égal à un courant de fuite à la borne de substrat du deuxième transistor (M2 ; P2).

15. Procédé suivant une quelconque des revendications 11 ou 12, comprenant en outre appliquer un signal en tension alternative à l'interrupteur de fréquence radio par une source de tension de fréquence radio.

**FIG. 1**

**FIG. 2A**

EP 3 720 001 B1

FIG. 2B

**FIG. 3**

**FIG. 4**

**FIG. 5**

**FIG. 6**

**FIG. 7**

**FIG. 8A**

800B

| | Positive Half - Period | | | Negative Half - Period | | |
|---|---|---|---|---|---|---|
| | AC Voltage | DC Voltage | Pos. Peak AC + DC | AC Voltage | DC Voltage | Neg. Peak AC + DC |
| $V_{d2}$ | 6 V | 0 V | 6 V | -6 V | 0 V | -6 V |
| $V_{b2}$ | 4.5 V | -2 V | 2.5 V | -4.5 V | -2 V | -6.5 V |
| $V_{d1}$ | 3 V | 0 V | 3 V | -3 V | 0 V | -3 V |
| $V_{b1}$ | 1.5 V | -2 V | -0.5 V | -1.5 V | -2 V | -3.5 V |
| $V_{s1}$ | 0 V | 0 V | 0 V | 0 V | 0 V | 0 V |

**FIG. 8B**

EP 3 720 001 B1

FIG. 9A

EP 3 720 001 B1

FIG. 9B

EP 3 720 001 B1

FIG. 10A

FIG. 10B

FIG. 11

**FIG. 12**

**FIG. 13**

EP 3 720 001 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017237432 A1
- US 2015035582 A1

- US 2019013806 A1